# EUROPÄISCHE PATENTSCHRIFT

(11) **EP 3 454 029 B1**
(45) Veröffentlichungstag und Bekanntmachung des Hinweises auf die Patenterteilung: **25.08.2021**
(21) Anmeldenummer: 17190525.0
(22) Anmeldetag: 12.09.2017
(51) Int. Cl.: G01K 17/00, C23C 14/06, C23C 14/02, C23C 14/04, C23C 16/04, C23C 16/26, G01N 25/22, B01L 3/04

(54) **HOCHDRUCKKAPSEL MIT BESCHICHTUNG**
HIGH PRESSURE CAPSULE WITH COATING
CAPSULE HAUTE PRESSION DOTÉE DU REVÊTEMENT

(43) Veröffentlichungstag der Anmeldung: 13.03.2019
(73) Patentinhaber: TÜV SÜD Schweiz AG, 8048 Zürich (CH)
(72) Erfinder: BÄCHLER, Martin Alexander, 4436 Oberdorf (CH)
(74) Vertreter: Piticco, Lorena

(56) Entgegenhaltungen:
- EP-A1- 2 243 858
- EP-A1- 2 492 669
- DE-U1- 29 504 803
- US-A1- 2004 149 759
- US-A1- 2014 260 955

## Beschreibung

### TECHNISCHES GEBIET

Die vorliegende Erfindung betrifft eine Hochdruckkapsel für kalorimetrische Messungen und ein Verfahren zur Herstellung einer solchen Hochdruckkapsel.

### STAND DER TECHNIK

Hochdruckkapseln werden in der Kalorimetrie zur Messung von Wärmemengen eingesetzt, welche an biologische, chemische oder physikalische Vorgänge gekoppelt sind und je nach Vorgang exotherm oder endotherm verlaufen können. Insbesondere die dynamische Differenzkalorimetrie wird oftmals in der Qualitätskontrolle oder für die Abklärung der thermischen Sicherheit von chemischen Produktionsverfahren eingesetzt. Dabei werden eine erste Hochdruckkapsel mit einer Probe und eine zweite Hochdruckkapsel ohne Inhalt, als Referenz, gemäss einem festen Temperaturprogramm kontrolliert aufgeheizt, wobei Differenzen von Wärmeströmen zu der Probe und der Referenz als Funktion der Temperatur gemessen werden. Aus diesen Differenzen können dann beispielsweise Informationen über Phasenumwandlungen gewonnen oder die spezifische Wärmekapazität bestimmt werden. Bei einer solchen mikrokalorimetrischen Messmethode können auch sehr kleine Probenmengen im Mikroliterbereich untersucht werden, wobei im Falle von Abklärungen zur thermischen Sicherheit die Edukte, Produkte und Reaktionsmischungen zu verschiedenen Reaktionszeiten untersucht werden. Verschiedene Hochdruckkapseln sind aus dem Stand der Technik bekannt.

So ist aus der CH 696 370 A5 eine Hochdruckkapsel für kalorimetrische Messungen bekannt, welche einen Tiegel aus Stahl und einen Deckel zum Verschliessen des Tiegels aus Gold oder mit einer Goldbeschichtung umfasst.

In der DE 295 04 803 U1 wird ein Verbrennungsbehälter für Kalorimeter offenbart, welcher aus Titan besteht. Die bei einem Behälter aus Titan von selbst entstehende Oxidschicht verhindert einen Austritt von Bestandteilen aus der Behälterwand in die zu analysierende Probe.

Aus der EP 0 646 230 B1 ist ein Tiegel aus Siliziumdioxid mit einem Überzug aus einem Metalloxid bekannt. Im Innern des Tiegels wird eine Substanz aus chemischen Elementen aufgebracht, welche mit den Materialien verträglich sind, welche der Tiegel aufnehmen soll.

Die US 2004/149759 A1 offenbart einen gasdichten, druckresistenten Behälter für reaktive Füllmedien, welcher eine Anschlusskappe mit einer Verschlusseinrichtung umfasst. Die Behälterwandung besteht aus einem thermoplastischen Kunststoff mit einem Diffusionssperr- und/oder Korrosionsschutzsystem. Die Diffusionssperrschicht kann aus einer amorphen DLC Kohlenwasserstoffschicht bestehen. Weiterer relevanter Stand der Technik ist in dem Patentdokument EP 2 492 669 A1 offenbart.

Die Hochdruckkapseln sollten dabei hohen Temperaturen und einem hohen Druck standhalten können, weshalb oftmals Hochdruckkapseln aus Stahl verwendet werden. Die Reaktivität der Probe kann durch den Kontakt mit anderen Materialien, insbesondere Eisen und Stahl, jedoch signifikant verändert werden. Um einen Einfluss des Tiegelmaterials auf die zu untersuchende Probe zu reduzieren ist es daher bekannt, die Probengefässe mit einem edlen Metall wie beispielsweise Gold zu überziehen. Gold kann jedoch als Katalysator für die zu untersuchende Probe beziehungsweise bei deren chemischen Reaktion wirken und, falls diese katalytische Wirkung nicht bemerkt oder nicht richtig berücksichtigt wird, zu Fehlmessungen oder Fehlinterpretationen der Messungen führen. Um eine Wechselwirkung zwischen dem Material des Probengefässes und dessen Inhalt zu vermeiden, könnten zum Beispiel Glasampullen verwendet werden. Das Verschliessen von solchen Glasampullen mittels Mikrobrenner ist allerdings aufwändig und gefährdet infolge unerwünschter Aufheizung der Probe vor der Messung die Aussagekraft derselben.

### DARSTELLUNG DER ERFINDUNG

Es ist daher eine Aufgabe der vorliegenden Erfindung, eine Hochdruckkapsel für kalorimetrische Messungen anzugeben, bei welcher Wechselwirkungen zwischen der Hochdruckkapsel und einer zu messenden Probe minimiert sind. Insbesondere ist es eine Aufgabe, eine Hochdruckkapsel für kalorimetrische Messungen anzugeben, welche das Risiko von Fehlmessungen oder Fehlinterpretationen einer kalorimetrischen Messung reduziert und dabei über eine einfache Handhabung verfügt.

Diese Aufgabe wird durch eine Hochdruckkapsel gemäss Anspruch 1 und ein Verfahren gemäß Anspruch 10 gelöst. Demgemäss wird eine Hochdruckkapsel für kalorimetrische Messungen angegeben, die einen Tiegel, welcher einen Aufnahmeraum zur Aufnahme einer Probe umfasst, einen Deckel zum Verschliessen des Tiegels, und zumindest bereichsweise eine Beschichtung, insbesondere eine Innenbeschichtung, umfasst. Die Beschichtung umfasst mindestens eine amorphe Kohlenstoffschicht. Vorzugsweise wird die Beschichtung durch eine amorphe Kohlenstoffschicht gebildet, das heisst die Kohlenstoffschicht stellt den Hauptbestandteil oder sogar einzigen Bestandteil der Beschichtung dar.

Amorphe Kohlenstoffschichten werden auch als diamantähnliche Kohlenstoffschichten oder "Diamond-Like-Carbon" (DLC) bezeichnet. Wie aus dieser Bezeichnung hervorgeht, besitzt diamantähnlicher Kohlenstoff respektive die amorphe Kohlenstoffschicht einige der Eigenschaften von Diamant. Dazu gehören insbesondere eine extreme Härte, eine Abriebsfestigkeit, ein niedriger Reibungskoeffizient sowie chemische Resistenz. Dadurch, dass die Hochdruckkapsel über eine solche Beschichtung verfügt, wird eine Wechselwirkung zwischen der Hochdruckkapsel und einer zu untersuchenden Probe zumindest im Bereich der Beschichtung verhindert. Dies führt dazu, dass Fehlmessungen oder Fehlinterpretationen der Messergebnisse reduziert oder sogar vermieden werden.

Die amorphe Kohlenstoffbeschichtung kann ein Einschichtsystem mit nur einer amorphen Kohlenstoffschicht oder ein Mehrschichtsystem mit zwei oder mehr solcher amorphen Kohlenstoffschichten sein. Bevorzugt weist die amorphe Kohlenstoffbeschichtung eine Schichtdicke im Bereich von 0.5 bis 3.5 Mikrometer, insbesondere von 0.8 bis 2.8 Mikrometer auf.

Die amorphe Kohlenstoffschicht kann ausgewählt sein aus der Gruppe bestehend aus wasserstofffreier amorpher Kohlenstoffschicht, tetraedrischer wasserstofffreier amorpher Kohlenstoffschicht, metallhaltiger wasserstofffreier amorpher Kohlenstoffschicht, wasserstoffhaltiger amorpher Kohlenstoffschicht, tetraedrischer wasserstoffhaltiger amorpher Kohlenstoffschicht, metallhaltiger wasserstoffhaltiger amorpher Kohlenstoffschicht und modifizierter wasserstoffhaltiger amorpher Kohlenstoffschicht, und ist insbesondere eine wasserstoffhaltige amorphe Kohlenstoffschicht.

Es können also verschiedene Schichttypen von amorphen Kohlenstoffschichten für die Beschichtung der Hochdruckkapsel verwendet werden, wobei insbesondere eine Beschichtung aus einer wasserstoffhaltigen amorphen Kohlenstoffschicht bevorzugt ist. Die Schichttypen werden hier gemäss den VDI (Verein Deutscher Ingenieure) Richtlinien VDI 2840 unterschieden. Bei einer modifizierten wasserstoffhaltigen amorphen Kohlenstoffschicht erfolgt eine Dotierung mit Elementen wie Silizium, Sauerstoff, Stickstoff, Fluor oder Bor.

Die amorphe Kohlenstoffbeschichtung weist abhängig vom Schichttyp und insbesondere im Hinblick auf dessen beabsichtigte Anwendung bestimmte Eigenschaften auf. Im Falle der bevorzugten amorphen Kohlenstoffbeschichtung aus einer wasserstoffhaltigen amorphen Kohlenstoffschicht bei einer Hochdruckkapsel sind dies eine maximale Anwendungstemperatur von grösser als 250°, insbesondere etwa 400°C und/oder ein Mikrohärtewert von grösser als 1000 HV 0.05, insbesondere etwa 2500 HV 0.05 und/oder ein Reibwert gegen trockenen Stahl im Bereich von etwa 0.02 bis 0.3, insbesondere von etwa 0.1 bis 0.2.

Amorphe Kohlenstoffbeschichtungen sind je nach Schichttyp beziehungsweise deren Verwendung unter unterschiedlichen Handelsnahmen bekannt. Beispiele von Handelsnahmen sind BALINIT® TRITON, BALINIT® C, BALINIT® HARD CARBON, BALINIT® DYLYN, BALINIT® DYLYN PLUS, BALINIT® DYLYN PRO, wobei die Bezeichnung "Triton" typischerweise für die Beschichtung von Werkzeugen verwendet wird. Bei der vorliegenden Hochdruckkapsel mit der bevorzugten amorphen Kohlenstoffbeschichtung aus einer wasserstoffhaltigen amorphen Kohlenstoffschicht kann eine amorphe Kohlenstoffschicht bekannt unter dem Handelsnamen BALINIT® DLC verwendet werden.

Die amorphe Kohlenstoffschicht befindet sich im Bereich des Aufnahmeraums der Hochdruckkapsel. So ist die Beschichtung zumindest bereichsweise auf einer dem Aufnahmeraum zugewandten oder, in anderen Worten, auf einer den Aufnahmeraum begrenzenden Fläche der Hochdruckkapsel angeordnet. Im Falle eines mit dem Deckel verschlossenen Tiegels ist es bevorzugt, dass die Beschichtung den Aufnahmeraum vollständig umgibt.

Vorzugsweise weist der Tiegel eine im Wesentlichen zylindrische Grundform mit einer Aussenfläche und einer Innenfläche auf. Der Aufnahmeraum zur Aufnahme der Probe wird dabei von der Innenfläche des Tiegels begrenzt. Beim Deckel handelt es sich bevorzugt um eine im Wesentlichen kreisförmige Verschlussscheibe oder Verschlussmembran, welche über eine Umfangsfläche sowie zwei Aussenflächen verfügt. Die Beschichtung kann zumindest bereichsweise auf der den Aufnahmeraum begrenzenden Innenfläche des Tiegels angeordnet sein, und/oder die Beschichtung kann zumindest bereichsweise auf einer Aussenfläche des Deckels, insbesondere auf derjenigen Aussenfläche, welche im Falle eines mit dem Deckel verschlossenen Tiegels dem Aufnahmeraum zugewandt ist, angeordnet sein. Dabei ist die amorphe Kohlenstoffbeschichtung vorzugsweise entlang der gesamten den Aufnahmeraum begrenzenden Innenfläche des Tiegels sowie auf einer Fläche an der dem Aufnahmeraum zugewandten Aussenseite des Deckels angeordnet, welche der Querschnittsfläche des Aufnahmeraums entspricht. Ist der Tiegel mit dem Deckel verschlossen, so ist der gesamte Aufnahmeraum von der Beschichtung umgeben und eine Wechselwirkung zwischen einer aufgenommenen Probe und dem Material der Hochdruckkapsel ist verhindert.

Die Hochdruckkapsel kann weiter mindestens eine Haftschicht umfassen, welche zwischen der Beschichtung und dem Tiegel und/oder zwischen der Beschichtung und dem Deckel angeordnet ist, und wobei die Haftschicht eine Nitridschicht, insbesondere aus Chromnitrid, oder eine Titanschicht umfasst. Die Haftschicht ist für eine Haftvermittlung zwischen dem Tiegel beziehungsweise dem Deckel und der amorphen Kohlenstoffbeschichtung vorgesehen. Die Schichtdicke der Haftschicht kann zwischen 0.1 bis 0.3 Mikrometer, insbesondere 0.2 Mikrometer betragen. Vorzugsweise sind bei der Hochdruckkapsel die Beschichtung umfassend die amorphe Kohlenstoffschicht und die Haftschicht somit in Form eines Mehrschichtsystems vorgesehen, wobei die gesamte Schichtdicke des Mehrschichtsystems im Bereich von 0.6 bis 3.8 Mikrometer, vorzugsweise von 1 bis 3 Mikrometer liegt.

Die Hochdruckkapsel kann weiter mindestens eine weitere Beschichtung umfassen, wobei die weitere Beschichtung mindestens ein Metall, insbesondere Gold, umfasst und in einem Bereich der Hochdruckkapsel angeordnet ist, wo keine Beschichtung umfassend die mindestens eine amorphe Kohlenstoffschicht vorhanden ist. Die weitere Beschichtung kann zum Beispiel angrenzend oder beabstandet zum Bereich der Hochdruckkapsel mit der Beschichtung umfassend die mindestens eine amorphe Kohlenstoffschicht angeordnet sein. Bevorzugterweise ist zwischen der weiteren Beschichtung aus beispielsweise Gold und dem Material der Hochdruckkapsel keine Haftschicht vorgesehen. Das heisst, die weitere Beschichtung wird vorzugsweise direkt auf der Hochdruckkapsel aufgebracht, wobei das Aufbringen zum Beispiel mittels des Trommelverfahrens erfolgen kann.

So kann in einem oberen Bereich des Tiegels eine Aufnahme für den Deckel ausgebildet sein, wobei sich die weitere Beschichtung auf der die Aufnahme begrenzenden Innenfläche des Tiegels befindet, und/oder wobei sich die weitere Beschichtung auf einer Umfangsfläche des Deckels befindet, welche im Falle eines verschlossenen Tiegels der die Aufnahme begrenzenden Innenfläche des Tiegels zugewandt ist.

Das heisst, es ist denkbar den Tiegel und/oder den Deckel in einem ersten Bereich mit der amorphen Kohlenstoffbeschichtung und in einem zweiten Bereich mit beispielsweise einer Goldbeschichtung zu versehen. Beispielsweise kann also eine Goldbeschichtung einzig im Bereich der Aufnahme des Tiegels und auf der Umfangsfläche des Deckels angebracht werden, während der Aufnahmeraum des Tiegels und die dem Aufnahmeraum zugewandte Aussenfläche des Deckels einzig die amorphe Kohlenstoffbeschichtung und gegebenenfalls die Haftschicht aufweisen. Das heisst, der die Probe aufnehmende Aufnahmeraum ist dann einzig der amorphen Kohlenstoffbeschichtung, nicht aber der Goldbeschichtung ausgesetzt. Dadurch wird eine ungewollte katalytische Wirkung durch die Goldbeschichtung vermieden. Die Goldschicht ist jedoch an der Verschlussstelle zwischen dem Deckel und dem Tiegel vorhanden, wodurch eine einwandfreie Verpressung bezüglich Druckdichtigkeit beim Verschliessen des Tiegels mit dem Deckel gewährleistet wird.

Der Tiegel ist aus Stahl hergestellt. Der Deckel kann mindestens ein Metall umfassen und kann insbesondere aus Stahl hergestellt sein. Vorzugsweise sind der Tiegel und der Deckel aus Stahl der Stahlsorte 1.4435 gefertigt. Es ist jedoch auch denkbar, dass insbesondere der Deckel aus einem anderen Metall besteht oder vergoldet ist.

Ein Tiegel beziehungsweise ein Deckel aus Stahl bringen den Vorteil, dass die mit amorphem Kohlenstoff beschichtete Hochdruckkapsel nicht nur über eine chemische Resistenz, sondern auch über eine sehr hohe Druckbeständigkeit verfügt. Die amorphe Kohlenstoffbeschichtung verhindert dabei, dass die Reaktivität von gewissen Proben aufgrund eines Kontakts mit dem Stahl verändert wird.

Ein Verfahren zur Herstellung einer Hochdruckkapsel, insbesondere einer Hochruckkapsel wie oben beschrieben, mit einem Tiegel und einem Deckel zum Verschliessen des Tiegels umfasst das zumindest teilweise Beschichten der Hochdruckkapsel mit einer Beschichtung umfassend mindestens eine amorphe Kohlenstoffschicht.

Das Beschichten kann durch Abscheiden von amorphem Kohlenstoff mittels einer chemischen und/oder physikalischen Gasphasenabscheidung, vorzugsweise mittels einer plasmaunterstützen chemischen Gasphasenabscheidung erfolgen. Vorzugsweise werden nur die den Aufnahmeraum unmittelbar begrenzenden Bereiche der Hochdruckkapsel vollständig oder zum Teil beschichtet.

Das Abscheiden kann bei einer Temperatur im Bereich von 150°C bis 300°C, insbesondere von 180°C bis 250°C erfolgen.

Vor dem Beschichten der Hochdruckkapsel mit der Beschichtung kann mindestens eine Haftschicht durch Sputtern auf den Tiegel und/oder den Deckel aufgebracht werden, wobei die Haftschicht vorzugsweise eine Nitridschicht, insbesondere aus Chromnitrid, oder eine Titanschicht umfasst.

Auch kann eine weitere Beschichtung umfassend mindestens ein Metall, insbesondere Gold, auf den Tiegel und/oder den Deckel aufgebracht werden.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: einen Querschnitt durch eine schematisch dargestellte Hochdruckkapsel im unverschlossenen Zustand umfassend einen Tiegel gemäss einer ersten Ausführungsform, einen Deckel, eine Beschichtung sowie eine weitere Beschichtung;
- Fig. 2: einen Querschnitt durch die Hochdruckkapsel gemäss Figur 1 im verschlossenen Zustand;
- Fig. 3: einen Querschnitt durch eine Hochdruckkapsel im unverschlossenen Zustand umfassend einen Tiegel gemäss einer zweiten Ausführungsform und einen Deckel;
- Fig. 4: eine Detailansicht des Bereichs A in Figur 3;
- Fig. 5: eine Detailansicht des Bereichs A in Figur 3 mit einem Tiegel gemäss einer dritten Ausführungsform;
- Fig. 6: einen Querschnitt durch die Hochdruckkapsel gemäss Figur 3 im verschlossenen Zustand;
- Fig. 7: einen Querschnitt durch einen Tiegel gemäss einer vierten Ausführungsform; sowie
- Fig. 8: Vergleichsmessungen der Wärmeleistung einer Probe aus Wasserstoffperoxid mit einer Hochdruckkapsel aus Stahl, mit einer vergoldeten Hochdruckkapsel, mit einer erfindungsgemässen Hochdruckkapsel sowie mit einer Glasampulle.

### BESCHREIBUNG BEVORZUGTER AUSFÜHRUNGSFORMEN

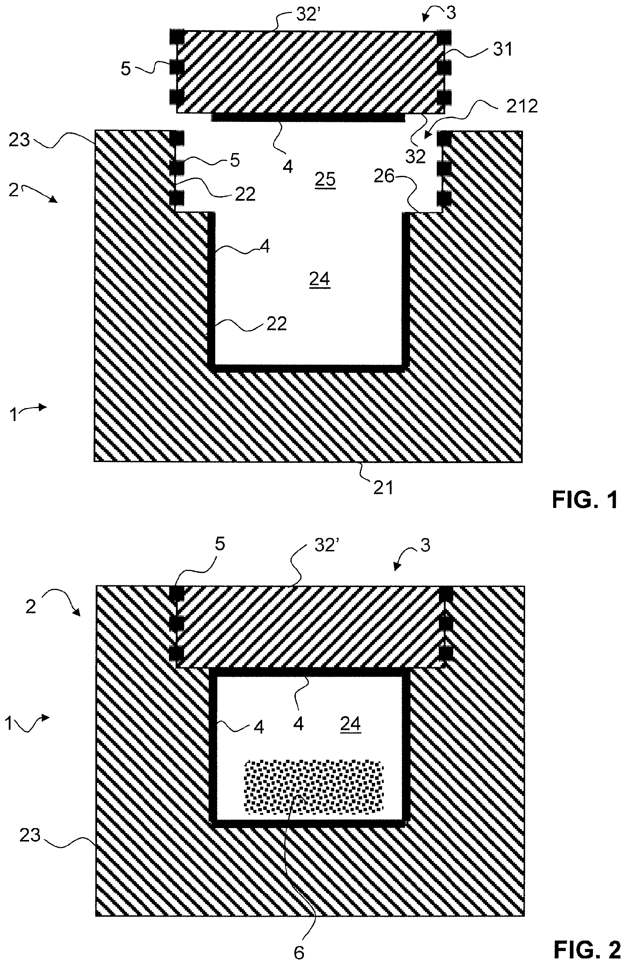

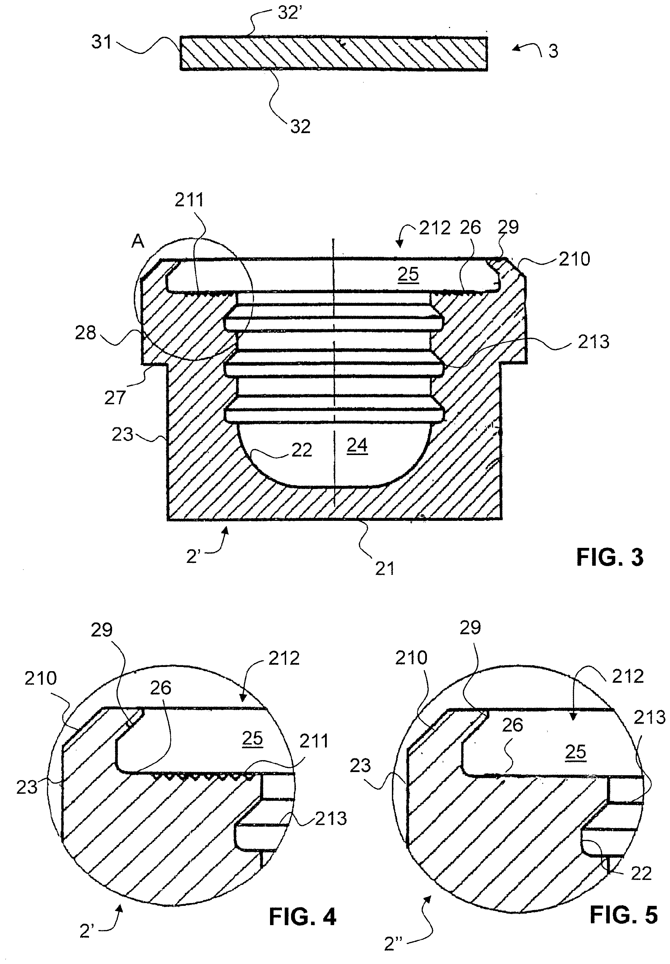

Eine erfindungsgemässe Hochdruckkapsel 1 ist in den Figuren 1 und 2 schematisch dargestellt. Diese Hochdruckkapsel umfasst einen Tiegel 2 gemäss einer ersten Ausführungsform, einen Deckel 3, eine Beschichtung 4 sowie eine weitere Beschichtung 5. In den Figuren 3 bis 7 wurden die Beschichtungen der Übersicht halber nicht dargestellt. Aussagen, welche für diese Beschichtungen im Zusammenhang mit der Hochdruckkapsel der Figuren 1 und 2 gemacht werden, gelten jedoch gleichermassen für die Hochdruckkapseln gemäss den Figuren 3 bis 7. Zudem sei angemerkt, dass diese Aussagen auch für die in den Figuren 3 bis 7 gezeigten Tiegel 2', 2", 2‴ gemäss den weiteren Ausführungsformen gelten.

Wie aus den Figuren 1 und 2 hervorgeht, umfasst die Hochdruckkapsel 1 einen Tiegel 2, welcher einen nach oben offenen, im Wesentlichen zylinderförmigen Aufnahmeraum 24 zur Aufnahme einer Probe 6 umfasst. In diesen schematischen Darstellungen ist der Tiegel 2 ebenfalls im Wesentlichen zylinderförmig ausgebildet und weist eine Aussenfläche 23 und eine den Aufnahmeraum 24 begrenzende Innenfläche 22 auf. In einem oberen Bereich des Tiegels 2 verbreitert sich der Aufnahmeraum 24 und bildet eine umlaufende Auflagefläche 26, so dass eine Aufnahme 25 zur Aufnahme des Deckels 3 sowie eine Auflagefläche 26 zur Auflage des aufgenommenen Deckels 3 gebildet werden. Der Deckel 3 ist hier in Form einer Verschlussscheibe oder Verschlussmembran dargestellt und dazu ausgebildet, beim Verschliessen des Tiegels 2 in der Aufnahme 25 des Tiegels aufgenommen zu werden.

Weiter weist der Tiegel 2 auf der den Aufnahmeraum 24 begrenzenden Innenfläche 22 eine Beschichtung 4 auf, welche hier mittels der durchgezogenen dicken Linie angedeutet wird. Auch der Deckel 3 ist auf seiner Aussenfläche bereichsweise mit einer solchen Beschichtung 4 versehen. Und zwar ist die Beschichtung 4 hier auf einer unteren Oberfläche 32 des Deckels 3 vorgesehen, welche im Falle des mit dem Deckel 3 verschlossenen Tiegels 2 dem Aufnahmeraum 24 des Tiegels 2 zugewandt ist und diesen verschliesst. Wie aus diesen Figuren hervorgeht, erstreckt sich die Beschichtung 4 des Tiegels 2 entlang der gesamten den Aufnahmeraum 24 begrenzenden Innenfläche 22, wobei einzig die Auflagefläche 26 und die die Aufnahme 25 begrenzende Innenfläche 22 unbeschichtet sind. Beim Deckel 3 bedeckt die Beschichtung 4 eine Fläche auf der unteren Oberfläche 32, welche im Wesentlichen der parallel zu einer planen Grundfläche 21 des Tiegels 2 verlaufenden Querschnittsfläche des Aufnahmeraums 24 entspricht. Ist der Tiegel 2 mit dem Deckel 3 verschlossen, so ist der Aufnahmeraum 24 somit vollständig von der Beschichtung 4 umgeben.

Bei dieser Beschichtung 4 handelt es sich um eine oder mehrere amorphe Kohlenstoffschichten, welche auch als sogenannte "Diamond-Like-Carbon" (DLC) beziehungsweise diamantähnliche Kohlenstoffschichten bekannt sind. Vorzugsweise werden dabei wasserstoffhaltige amorphe Kohlenstoffschichten verwendet, welche auch unter dem Namen BALINIT® DLC vertrieben werden. Allerdings sind auch weitere amorphe Kohlenstoffschichten, wie zum Beispiel wasserstofffreie, wasserstoffhaltige, metallhaltige oder halbmetallhaltige amorphe Kohlenstoffschichten, denkbar. Dadurch, dass eine im Aufnahmeraum 24 der Hochdruckkapsel 1 eingeschlossene Probe 6 vollständig von einer oder mehreren amorphen Kohlenstoffschichten umgeben ist, wird eine im Wesentlichen chemisch inerte Hochdruckkapsel 1 zur Verfügung gestellt. Nebst einer guten Korrosionsbeständigkeit verfügen amorphe Kohlenstoffschichten ebenfalls über einen tiefen Reibungskoeffizienten sowie eine hohe Schichthärte.

Eine Wechselwirkung zwischen dem Material des Tiegels 2 beziehungsweise des Deckels 3 mit der zu untersuchenden Probe 6 wird somit Dank der Beschichtung 4 aus amorphem Kohlenstoff verhindert, wodurch Fehlmessungen oder Fehlinterpretationen einer kalorimetrischen Messung mittels einer solchen Hochdruckkapsel 1 reduziert oder sogar vermieden und folglich die Messgenauigkeit erhöht werden. Indem das Tiegelbeziehungsweise Deckelmaterial von der zu untersuchenden Probe 6 chemisch nicht angegriffen werden kann, wird zudem die Lebensdauer der Hochdruckkapsel 1 erhöht.

Obwohl in den Figuren nicht ersichtlich, kann nebst diesen amorphen Kohlenstoffschichten auch mindestens eine Haftschicht vorhanden sein, welche zwischen der amorphen Kohlenstoffbeschichtung 4 und der entsprechenden Innenfläche 22 des Tiegels 2 beziehungsweise unteren Oberfläche 32 des Deckels 3 angeordnet ist.

Vorzugsweise handelt es sich bei der Haftschicht um eine Schicht aus Chromnitrid. Der Tiegel 2 und der Deckel 3 sind im vorliegenden Beispiel aus Stahl gefertigt. Vorzugsweise handelt es sich beim Stahl um einen Edelstahl mit der Werkstoffnummer 1.4435 respektive mit der AISI (American Iron and Steel Institute) 316L, welche X2CrNiMo18-14-3 bezeichnet. Wie nachfolgend im Zusammenhang mit den Figuren 3 bis 7 genauer erläutert wird, ist es jedoch genauso denkbar, den Deckel 3 aus Reingold oder aus vergoldeten metallischen Substraten zu fertigen, und die amorphen Kohlenstoffschichten 4 auf diesen Substraten anzubringen. Ein Tiegel 2 und gegebenenfalls auch ein Deckel 3 aus Stahl bringen allerdings den Vorteil, dass die Hochdruckkapsel nicht nur über eine chemische Resistenz, sondern auch über eine sehr hohe Druckbeständigkeit verfügt.

Die Hochdruckkapsel 1 kann nebst der Beschichtung 4 umfassend amorphen Kohlenstoff und gegebenenfalls der Haftschicht eine weitere Beschichtung 5 aufweisen. In den Figuren 1 und 2 ist diese weitere Beschichtung 5 durch Quadrate angedeutet, welche sich entlang der die Aufnahme 25 begrenzenden Innenfläche 22 des Tiegels 2 sowie entlang der Umfangsfläche 31 des Deckels 3, welche im Falle des verschlossenen Tiegels 2 dieser Innenfläche 22 zugewandt ist, erstrecken. Es gilt zu verstehen, dass diese weitere Beschichtung 5 wie auch die Beschichtung 4 aus amorphen Kohlenstoffschichten jeweils eine durchgehende Beschichtung bilden und die unterbrochenen Quadrate im Zusammenhang mit der weiteren Beschichtung 5 einzig für die Unterscheidung von der Beschichtung 4 in Form der durchgezogenen dicken Linie dienen. Bei dieser weiteren Beschichtung 5 handelt es sich um eine metallhaltige Beschichtung, die vorzugsweise Gold umfasst respektive eine Goldschicht ist. Wie in den Figuren ersichtlich ist, erstreckt sich die weitere Beschichtung 5 im Tiegel 2 ausgehend von der Auflagefläche 26 in Richtung der oberen Öffnung 212 des Tiegels 2 entlang der gesamten Innenfläche 22 des Tiegels 2. Analog erstreckt sich die weitere Beschichtung 5 am Deckel 3 entlang dessen gesamten Umfangsfläche 31. Es ist jedoch auch denkbar, dass nur die Innenfläche 22 des Tiegels 2 oder nur die Umfangsfläche 31 des Deckels 3 mit der Goldbeschichtung versehen ist. Ebenso ist es möglich, dass auch die Auflagefläche 26 des Tiegels 2 mit einer Goldschicht beschichtet ist. Zudem ist es denkbar, dass keine weitere Beschichtung 5 am Tiegel 2 vorgesehen ist und stattdessen die gesamte Innenfläche 22 mit der Beschichtung aus amorphen Kohlenstoffschichten beschichtet ist.

Typischerweise weist die Beschichtung 4 aus amorphen Kohlenstoffschichten eine Schichtdicke von etwa 2.5 Mikrometer und die weitere Beschichtung 5 eine Schichtdicke von etwa 10 Mikrometer auf. Die Schichtdicke der Haftschicht beträgt normalerweise etwa 0.2 Mikrometer.

Während sich die bisherigen Erklärungen vor allem auf die unterschiedlichen Beschichtungen der Hochdruckkapsel 1 bezogen und diese dabei in den Figuren 1 und 2 nur schematisch dargestellt wurde, werden nun im Zusammenhang mit den Figuren 3 bis 7 mögliche konkrete Ausgestaltungen des Tiegels 2', 2", 2‴ sowie des Deckels 3 der Hochdruckkapsel 1 eingehend erläutert. Der Tiegel 2', 2" und der Deckel 3 entsprechen dabei dem Tiegel und dem Deckel, wie sie in der CH 696 370 offenbart werden. Die CH 696 370 wird daher hierin in ihrer Gesamtheit unter ausdrücklichem Verweis aufgenommen. Wie eingangs bereits erwähnt, wurden in den Figuren 3 bis 7 die Beschichtung 4, die weitere Beschichtung 5 sowie die Haftschicht der Übersicht halber weggelassen. Es gilt allerdings zu verstehen, dass diese Beschichtungen 4, 5 sowie die Haftschicht wie oben erläutert bei den nun beschriebenen Tiegeln 2', 2", 2‴ und dem Deckel 3 vorhanden sind. Das heisst, insbesondere ist eine Beschichtung 4 umfassend mindestens eine amorphe Kohlenstoffschicht im Bereich des Aufnahmeraums, z.B. auf der Innenfläche 22 des Tiegels 2', 2", 2‴ und gegebenenfalls auf der Fläche 32 des Deckels 3, sowie eine weitere Beschichtung 5 aus beispielsweise Gold auf der Umfangsfläche 31 des Deckels 3 vorgesehen.

In den Figuren 3 bis 4 und 6 ist eine Hochdruckkapsel 1 mit einem Tiegel 2' gemäss einer zweiten Ausführungsform dargestellt. Anders als in den schematischen Figuren 1 und 2 weist der Tiegel 2' zwar ebenfalls eine zylindrische Grundform auf, wobei allerdings ein unterer Bereich über eine Stufe 27 in einen Kragen 28 mit einem grösseren Aussendurchmesser übergeht. Sowohl ein Teil des Aufnahmeraums 24, die Auflagefläche 26 wie auch die gesamte Aufnahme 25 befinden sich im Bereich des Kragens 28. Oberhalb der Auflagefläche 26 weist der Kragen 28 eine radial in die Aufnahme 25 hineinragende, umlaufende Rückhaltenase 29 auf. An seiner Aussenseite ist der Kragen 28 in diesem Bereich vorzugsweise mit einer umlaufenden abgeschrägten Kante 210 versehen.

Die Auflagefläche 26 ist planar ausgebildet und verläuft mindestens annähernd parallel zur planen Grundfläche 21 des Tiegels. Die Auflagefläche 26 verfügt über eine speziell behandelte Oberfläche, so dass eine Kaltverschweissung zur Verschliessung des Tiegels 2' mit dem Deckel 3 ermöglicht ist. In diesem Beispiel sind es Mikrostrukturen 211, wie dies insbesondere in Figur 4 sichtbar ist. Es handelt sich dabei um Rillen 211, welche vorzugsweise eine sägezahnartige Form aufweisen, und vorzugsweise eine Tiefe und Breite von 0.05 mm aufweisen. Diese Mikrostrukturen 211 sind hier unterbrechungsfrei über den gesamten Radius der Auflagefläche 26 angeordnet, wobei sie sich radial über mindestens die halbe Breite der Auflagefläche 26 erstrecken.

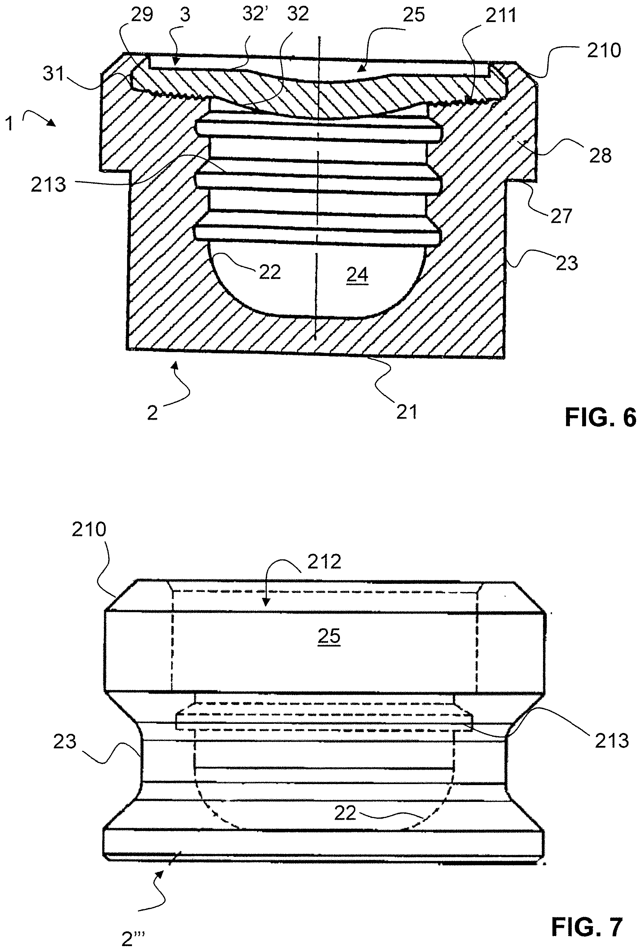

Um den Tiegel 2' zu verschliessen, wird der Deckel 3 auf die Auflagefläche 26 gelegt und mittels einer geeigneten Presse auf die Auflagefläche 26 gepresst. Ein relativ geringer Pressdruck reicht aus, um den Deckel 3 mit den Mikrostrukturen 211 der Auflagefläche 26 kaltzuverschweissen. Der so entstandene Verschluss ist bis zu 150 - 200 bar druckdicht. In Figur 6 ist die verschlossene Hochdruckkapsel 1 dargestellt, in welcher die Verformung des Deckels 3 sichtbar ist. Der Deckel 3 ragt dabei leicht in den Aufnahmeraum 24 hinein und hat sich entlang seines Umfangs an die Rückhaltenase 29 angeschmiegt.

Wie in den Figuren 3 und 6 sichtbar ist, können in der den Aufnahmeraum 24 begrenzenden Innenfläche 22 des Tiegels 2' eine oder mehrere umlaufende Rillen 213 ausgebildet sein. Diese Rillen 213 verhindern ein Kriechen der Probe 6 und somit ein Benetzen der Auflagefläche 26. In der Figur 5 ist der Tiegel 2" in einer dritten Ausführungsform dargestellt. Er weist anstelle der Mikrostrukturen 211 eine speziell glatte Oberfläche auf, um die Kaltverschweissung zu ermöglichen. Vorzugsweise ist die Oberfläche geläppt.

Ein Tiegel 2''' gemäss einer vierten Ausführungsform ist in Figur 7 gezeigt. Als typische Abmessungen weist dieser Tiegel 2''' eine Höhe von etwa 4.0 bis 6.0 Millimeter, insbesondere von etwa 4.5 Millimeter sowie einen Durchmesser von etwa 5.5 bis 8.0 Millimeter, insbesondere von etwa 7.0 Millimeter auf. Im Unterschied zu den Tiegeln 2', 2" gemäss der zweiten und dritten Ausführungsform weist der vorliegende Tiegel 2‴ einen unteren Bereich auf, dessen Aussendurchmesser kleiner als der Aussendurchmeser des oberen Bereichs ist.

Diese Hochdruckkapseln 1 ermöglicht ein Kaltverschweissen mit einem relativ geringen Pressdruck Die erfindungsgemässen Rillen verhindern ein Benetzen der Auflagefläche des Tiegels und ermöglichen die Kaltverschweissung und verbessern zudem das Oberflächen/Volumenverhältnis.

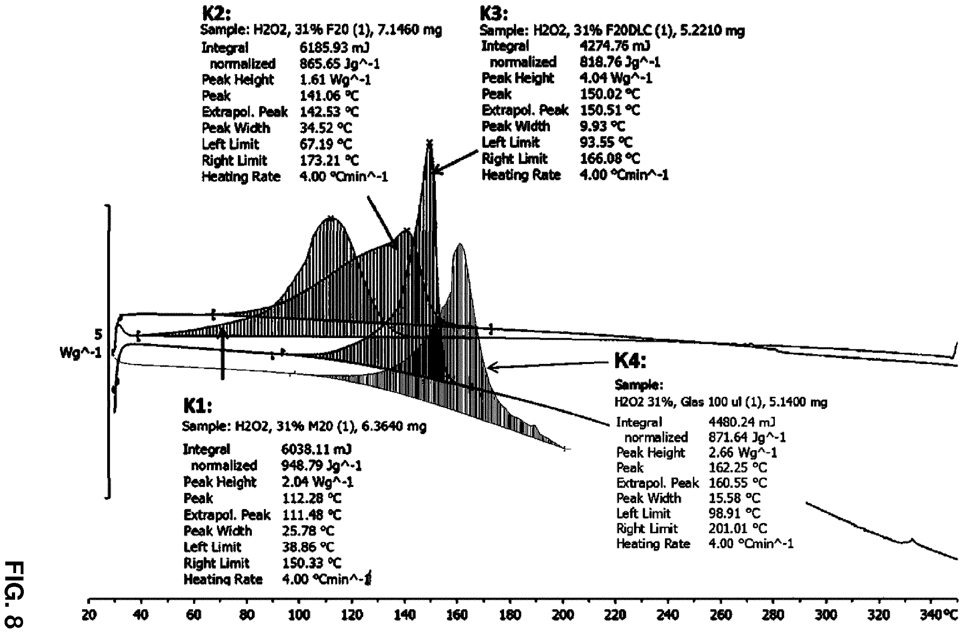

Um den Einfluss der Hochdruckkapsel auf die Ergebnisse der kalorimetrischen Messungen zu veranschaulichen, werden in Figur 8 Vergleichsmessungen der Wärmeleistung einer Probe aus Wasserstoffperoxid mit einer Hochdruckkapsel aus Stahl (Messung K1) , mit einer vergoldeten Hochdruckkapsel (Messung K2) sowie mit einer erfindungsgemässen Hochdruckkapsel 1 mit einer Beschichtung 4 aus amorphen Kohlenstoffschichten (Messung K3) dargestellt. Als Referenz dient die Messung K4 in einer Glasampulle. Insbesondere wurden dabei 7.1460 mg einer wässrigen 31%-igen Wasserstoffperoxid-Lösung in einem unvergoldeten Tiegel aus Stahl, 6.3640 mg einer wässrigen 31%-igen Wasserstoffperoxid-Lösung in einem goldbeschichteten Tiegel, 5.2210 mg einer wässrigen 31%-igen Wasserstoffperoxid-Lösung in einem mit amorphem Kohlenstoff beschichteten Tiegel und 5.1400 mg einer wässrigen 31%-igen Wasserstoffperoxid-Lösung in einer Glasampulle mit einer Aufheizrate von 4.00 °C pro Minute erhitzt. Wie dem Diagramm entnommen werden kann, setzte die Zerfallsreaktion von Wasserstoffperoxid in Wasser und Sauerstoff bei 38°C in der goldbeschichteten Kapsel, bei 67°C in der unbeschichteten Stahlkapsel, bei 93°C in der mit amorphem Kohlenstoff beschichteten Kapsel und bei 98°C in der Glasampulle ein.

Die tiefe Zerfallstemperatur im Falle der goldbeschichteten Hochdruckkapsel ist auf die katalytische Wirkung des Golds (siehe Journal of Catalysis, Volume 14, Issue 4, August 1969, Seiten 355-364) bei der Zerfallsreaktion von Wasserstoffperoxid zurück zu führen. Während auch bei der Hochdruckkapsel aus Stahl eine unerwünschte Wechselwirkung zwischen dem Material der Hochdruckkapsel und der Probe zu einer Temperaturerniedrigung führte (siehe Datenblatt Wasserstoffperoxid des Gefahrstoffinformationssystems Chemikalien der BG RCI und CEFIC H₂O₂ Bulk Storage Guideline, März 2012), wurde bei der Messung mit der mit amorphem Kohlenstoff beschichteten Hochdruckkapsel 1 der Beginn der Reaktion nahe dem mit der Glasampulle bestimmten Wert beobachtet. Dies belegt, dass in der mit amorphem Kohlenstoff beschichteten Hochdruckkapsel eine ähnlich geringe Beeinflussung der Reaktion vorliegt wie in der Glasampulle.

Gemäss Literatur (siehe Römpp Online, Georg Thieme Verlag, abgerufen am 1. Juli 2012) beträgt die Zersetzungsenergie von Wasserstoffperoxid 2888 J/g. Für eine 31 %-ige Wasserstoffperoxid-Lösung ergibt sich für diese Lösung somit eine Zersetzungsenergie von 895 J/g. Die ermittelten Werte von 948.79 J/g, 865.65 J/g, 818.76 J/g beziehungsweise 871.64 J/g für die Messung in der goldbeschichteten, der unbeschichteten, der mit amorphem Kohlenstoff beschichteten Hochdruckkapsel beziehungsweise der Glasampulle liegen innerhalb der für solche Messungen typischen Streuungen.

### BEZUGSZEICHENLISTE

- 1: Hochdruckkapsel

- 2,2', 2'',2''': Tiegel
- 21: Grundfläche
- 22: Innenfläche
- 23: Aussenfläche
- 24: Aufnahmeraum
- 25: Aufnahme
- 26: Auflagefläche
- 27: Stufe
- 28: Kragen
- 29: Rückhaltenase
- 210: abgeschrägte Kante
- 211: Mikrostrukturen
- 212: Öffnung
- 213: Rillen

- 3: Deckel
- 31: Umfangsfläche
- 32, 32': Oberfläche

- 4: Beschichtung aus amorphen Kohlenstoffschichten

- 5: metallhaltige Beschichtung

- 6: Probe

## Patentansprüche

1. Hochdruckkapsel (1) für kalorimetrische Messungen, umfassend:
einen Tiegel (2, 2', 2'', 2'''), welcher einen Aufnahmeraum (24) zur Aufnahme einer Probe (6) umfasst,
einen Deckel (3) zum Verschliessen des Tiegels (2, 2', 2", 2'''), und
zumindest bereichsweise eine Beschichtung (4),
wobei die Beschichtung (4) zumindest bereichsweise auf einer dem Aufnahmeraum (24) zugewandten Fläche (22, 32, 32') der Hochdruckkapsel (1) angeordnet ist,
**dadurch gekennzeichnet, dass** die Beschichtung (4) mindestens eine amorphe Kohlenstoffschicht umfasst, und
dass der Tiegel (2, 2', 2", 2‴)aus Stahl hergestellt ist.

2. Hochdruckkapsel (1) nach Anspruch 1, wobei die amorphe Kohlenstoffschicht ausgewählt aus der Gruppe bestehend aus wasserstofffreier amorpher Kohlenstoffschicht, tetraedrischer wasserstofffreier amorpher Kohlenstoffschicht, metallhaltiger wasserstofffreier amorpher Kohlenstoffschicht, wasserstoffhaltiger amorpher Kohlenstoffschicht, tetraedrischer wasserstoffhaltiger amorpher Kohlenstoffschicht, metallhaltiger wasserstoffhaltiger amorpher Kohlenstoffschicht und modifizierter wasserstoffhaltiger amorpher Kohlenstoffschicht ist, und insbesondere eine wasserstoffhaltige amorphe Kohlenstoffschicht ist.

3. Hochdruckkapsel (1) nach einem der vorhergehenden Ansprüche, wobei die Beschichtung (4) eine maximale Anwendungstemperatur von grösser als 250 °C, insbesondere von etwa 400 °C, und/oder einen Mikrohärtewert von grösser als 1000 HV 0.05, insbesondere von grösser als 2500 HV 0.05, und/oder einen Reibwert gegen trockenen Stahl im Bereich von 0.02 bis 0.3, insbesondere von 0.1 bis 0.2 aufweist.

4. Hochdruckkapsel (1) nach einem der vorhergehenden Ansprüche, wobei die Beschichtung (4) im Falle, wenn der Tiegel (2, 2', 2'', 2''') vom Deckel (3) verschlossen ist, den Aufnahmeraum (24) vollständig umgibt.

5. Hochdruckkapsel (1) nach einem der vorhergehenden Ansprüche, wobei die Beschichtung (4) zumindest bereichsweise auf einer den Aufnahmeraum (24) begrenzenden Innenfläche (22) des Tiegels (2, 2', 2'', 2''') angeordnet ist,
und/oder wobei die Beschichtung (4) zumindest bereichsweise auf einer Fläche (32, 32') des Deckels (3) angeordnet ist, insbesondere auf derjenigen Fläche (32) des Deckels (3), welche dem Aufnahmeraum (24) zugewandt ist, wenn der Tiegel (2, 2', 2", 2‴) vom Deckel (3) verschlossen ist.

6. Hochdruckkapsel (1) nach einem der vorhergehenden Ansprüche, weiter umfassend mindestens eine Haftschicht, welche zwischen der Beschichtung (4) und dem Tiegel (2, 2', 2'', 2''') und/oder zwischen der Beschichtung (4) und dem Deckel (3) angeordnet ist, und wobei die Haftschicht eine Nitridschicht, insbesondere aus Chromnitrid, oder eine Titanschicht umfasst.

7. Hochdruckkapsel (1) nach einem der vorhergehenden Ansprüche, weiter umfassend mindestens eine weitere Beschichtung (5), wobei die weitere Beschichtung (5) mindestens ein Metall, insbesondere Gold, umfasst und insbesondere in einem Bereich der Hochdruckkapsel (1) angeordnet ist, wo keine Beschichtung (4) umfassend die mindestens eine amorphe Kohlenstoffschicht vorhanden ist.

8. Hochdruckkapsel (1) nach Anspruch 7, wobei in einem oberen Bereich des Tiegels (2, 2', 2", 2''') eine Aufnahme (25) für den Deckel (3) ausgebildet ist, und
wobei sich die weitere Beschichtung (5) auf einer die Aufnahme (25) begrenzenden Innenfläche (22) des Tiegels (2, 2', 2'', 2''') befindet, und/oder
wobei sich die weitere Beschichtung (5) auf einer Umfangsfläche (31) des Deckels (3) befindet, welche im Falle eines verschlossenen Tiegels (2, 2', 2", 2‴) der die Aufnahme (25) begrenzenden Innenfläche (22) des Tiegels (2, 2', 2", 2''') zugewandt ist.

9. Hochdruckkapsel (1) nach einem der vorhergehenden Ansprüche, wobei der Deckel (3) mindestens ein Metall umfasst, und insbesondere aus Stahl hergestellt ist.

10. Verfahren zur Herstellung einer Hochdruckkapsel (1), insbesondere einer Hochruckkapsel nach einem der vorhergehenden Ansprüche, mit einem Tiegel (2, 2', 2", 2‴) und einem Deckel (3) zum Verschliessen des Tiegels (2, 2', 2", 2‴), wobei das Verfahren den Schritt umfasst:
- zumindest bereichsweise Beschichten der Hochdruckkapsel (1) mit einer Beschichtung (4) umfassend mindestens eine amorphe Kohlenstoffschicht, wobei die Beschichtung (4) zumindest bereichsweise auf einer einem Aufnahmeraum (24) des Tiegels zugewandten Fläche (22, 32, 32') der Hochdruckkapsel (1) angeordnet ist, und wobei der Tiegel (2, 2', 2'', 2''')aus Stahl hergestellt ist.

11. Verfahren nach Anspruch 10, wobei das Beschichten durch Abscheiden von amorphem Kohlenstoff mittels einer chemischen und/oder physikalischen Gasphasenabscheidung, vorzugsweise mittels einer plasmaunterstützen chemischen Gasphasenabscheidung erfolgt.

12. Verfahren nach Anspruch 11, wobei das Abscheiden bei einer Temperatur im Bereich von 150°C bis 300°C, insbesondere von 180°C bis 250°C erfolgt.

13. Verfahren nach einem der Ansprüche 10 bis 12, wobei vor dem Beschichten der Hochdruckkapsel (1) mit der Beschichtung (4) mindestens eine Haftschicht durch Sputtern auf den Tiegel (2, 2', 2'', 2''') und/oder den Deckel (3) aufgebracht wird, und wobei die Haftschicht eine Nitridschicht, insbesondere aus Chromnitrid, oder eine Titanschicht umfasst.

14. Verfahren nach einem der Ansprüche 10 bis 13, wobei eine weitere Beschichtung (5) umfassend mindestens ein Metall, insbesondere Gold, auf den Tiegel (2, 2', 2", 2‴) und/oder den Deckel (3) aufgebracht wird.

## Claims

1. A high-pressure capsule (1) for calorimetric measurements comprising:
a crucible (2, 2', 2", 2‴) comprising a receiving space (24) for receiving a sample (6),
a lid (3) for closing the crucible (2, 2', 2", 2‴), and
a coating (4) at least regions,
wherein the coating (4) is arranged at least in regions on a surface (22, 32, 32') of the high-pressure capsule (1) facing the receiving space (24),
**characterized in that** the coating (4) comprises at least one amorphous carbon layer, and
that the crucible (2, 2', 2", 2‴) is made of steel.

2. The high-pressure capsule (1) of claim 1, wherein the amorphous carbon layer is selected from the group consisting of hydrogen-free amorphous carbon layer, tetrahedral hydrogen-free amorphous carbon layer, metal-containing hydrogen-free amorphous carbon layer, hydrogen-containing amorphous carbon layer, tetrahedral hydrogen-containing amorphous carbon layer, metal-containing hydrogen-containing amorphous carbon layer, and modified hydrogen-containing amorphous carbon layer, and in particular is a hydrogen-containing amorphous carbon layer.

3. The high-pressure capsule (1) according to any one of the preceding claims, wherein the coating (4) has a maximum application temperature of greater than 250 °C, in particular of about 400 °C, and/or a microhardness value of greater than 1000 HV 0.05, in particular of greater than 2500 HV 0.05, and/or a coefficient of friction against dry steel in the range from 0.02 to 0.3, in particular from 0.1 to 0.2.

4. The high-pressure capsule (1) according to any one of the preceding claims, wherein the coating (4), in the case when the crucible (2, 2', 2", 2‴) is closed by the lid (3), completely surrounds the receiving space (24).

5. The high-pressure capsule (1) according to any one of the preceding claims, wherein the coating (4) is arranged at least in regions on an inner surface (22) of the crucible (2, 2', 2", 2‴) delimiting the receiving space (24),
and/or wherein the coating (4) is arranged at least in regions on a surface (32, 32') of the lid (3), in particular on that surface (32) of the lid (3) which faces the receiving space (24) when the crucible (2, 2', 2", 2‴) is closed by the lid (3).

6. The high-pressure capsule (1) according to any one of the preceding claims, further comprising at least one adhesive layer which is arranged between the coating (4) and the crucible (2, 2', 2", 2‴) and/or between the coating (4) and the lid (3), and wherein the adhesive layer comprises a nitride layer, in particular of chromium nitride, or a titanium layer.

7. The high-pressure capsule (1) according to any one of the preceding claims, further comprising at least one further coating (5), wherein the further coating (5) comprises at least one metal, in particular gold, and is arranged in particular in a region of the high-pressure capsule (1) where no coating (4) comprising the at least one amorphous carbon layer is present.

8. The high-pressure capsule (1) according to claim 7, wherein a receptacle (25) for the lid (3) is formed in an upper region of the crucible (2, 2', 2", 2'''), and
wherein the further coating (5) is located on an inner surface (22) of the crucible (2, 2', 2", 2''') delimiting the receptacle (25), and/or
wherein the further coating (5) is located on a circumferential surface (31) of the lid (3) which, in the case of a closed crucible (2, 2', 2", 2‴), faces the inner surface (22) of the crucible (2, 2', 2", 2‴) delimiting the receptacle (25).

9. The high-pressure capsule (1) according to any one of the preceding claims, wherein the lid (3) comprises at least one metal, and in particular is made of steel.

10. A method of manufacturing a high-pressure capsule (1), in particular a high-pressure capsule according to any one of the preceding claims, comprising a crucible (2, 2', 2", 2‴) and a lid (3) for closing the crucible (2, 2', 2", 2'''), the method comprising the step of:
- coating the high-pressure capsule (1) at least in regions with a coating (4) comprising at least one amorphous carbon layer, the coating (4) being arranged at least in regions on a surface (22, 32, 32') of the high-pressure capsule (1) facing a receiving space (24) of the crucible, and the crucible (2, 2', 2", 2‴) being produced from steel.

11. The method according to claim 10, wherein the coating is carried out by depositing amorphous carbon by means of a chemical and/or physical vapor deposition, preferably by means of a plasma-assisted chemical vapor deposition.

12. The method according to claim 11, wherein the deposition is carried out at a temperature in the range of from 150°C to 300°C, in particular from 180°C to 250°C.

13. The method according to any one of claims 10 to 12, wherein, prior to coating the high-pressure capsule (1) with the coating (4), at least one adhesion layer is applied to the crucible (2, 2', 2", 2‴) and/or the lid (3) by sputtering, and wherein the adhesion layer comprises a nitride layer, in particular of chromium nitride, or a titanium layer.

14. The method according to any one of claims 10 to 13, wherein a further coating (5) comprising at least one metal, in particular gold, is applied to the crucible (2, 2', 2", 2‴) and/or the lid (3).

## Revendications

1. Capsule haute pression (1) pour mesures calorimétriques, comprenant:
un creuset (2, 2', 2", 2"') qui comprend un espace de réception (24) pour recevoir un échantillon (6),
un couvercle (3) pour fermer le creuset (2, 2', 2", 2"'), et
au moins dans certaines zones un revêtement (4),
dans laquelle le revêtement (4) est disposé au moins dans certaines zones sur une surface (22, 32, 32') de la capsule haute pression (1) tournée vers l'espace de réception (24),
**caractérisée en ce que** le revêtement (4) comprend au moins une couche de carbone amorphe, et
**en ce que** le creuset (2, 2', 2", 2‴) est réalisé en acier.

2. Capsule haute pression (1) selon la revendication 1, dans laquelle la couche de carbone amorphe est choisie dans le groupe consistant en une couche de carbone amorphe sans hydrogène, une couche de carbone amorphe tétraédrique sans hydrogène, une couche de carbone amorphe contenant un métal sans hydrogène, une couche de carbone amorphe contenant de l'hydrogène, une couche de carbone amorphe tétraédrique contenant de l'hydrogène, une couche de carbone amorphe contenant un métal contenant de l'hydrogène, et une couche de carbone amorphe modifié contenant de l' hydrogène, et en particulier, une couche de carbone amorphe contenant de l'hydrogène.

3. Capsule haute pression (1) selon l'une des revendications précédentes, dans laquelle le revêtement (4) présente une température maximale d'application supérieure à 250°C, notamment d'environ 400°C, et/ou une valeur de micro-dureté supérieure à 1000 HV 0,05, en particulier supérieure à 2500 HV 0,05, et / ou un coefficient de friction contre l'acier à sec dans la plage de 0,02 à 0,3, en particulier de 0,1 à 0,2.

4. Capsule haute pression (1) selon l'une des revendications précédentes, dans laquelle le revêtement (4) entoure complètement l'espace de réception (24) dans le cas où le creuset (2, 2', 2", 2‴) est fermé par le couvercle (3).

5. Capsule haute pression (1) selon l'une des revendications précédentes, dans laquelle le revêtement (4) est disposé au moins dans certaines zones sur une surface intérieure (22) du creuset (2, 2', 2", 2‴) délimitant l'espace de réception (24),
et/ou dans lequel le revêtement (4) est disposé au moins dans certaines zones sur une surface (32, 32') du couvercle (3), en particulier sur la surface (32) du couvercle (3) tournée vers l'espace de réception (24), lorsque le creuset (2, 2', 2", 2‴) est fermé par le couvercle (3).

6. Capsule haute pression (1) selon l'une des revendications précédentes, comprenant en outre au moins une couche adhésive, qui se situe entre le revêtement (4) et le creuset (2, 2', 2", 2‴) et/ou entre le revêtement (4) et le couvercle (3), et dans laquelle la couche adhésive comprend une couche de nitrure, en particulier en nitrure de chrome ou une couche de titane.

7. Capsule haute pression (1) selon l'une des revendications précédentes, comprenant en outre au moins un revêtement supplémentaire (5), dans laquelle le revêtement supplémentaire (5) comprend au moins un métal, en particulier de l'or, et en particulier est disposé dans une zone de la capsule à haute pression (1) dans laquelle aucun revêtement (4) comprenant l'au moins une couche de carbone amorphe est présente.

8. Capsule haute pression (1) selon la revendication 7, dans laquelle un réceptacle (25) pour le couvercle (3) est formé dans une zone supérieure du creuset (2, 2', 2", 2‴), et
dans lequel le revêtement supplémentaire (5) se trouve sur une surface intérieure (22) du creuset (2, 2', 2", 2‴) délimitant le réceptacle (25), et/ou
dans lequel le revêtement supplémentaire (5) se trouve sur une surface circonférentielle (31) du couvercle (3) qui, dans le cas d'un creuset fermé (2, 2', 2", 2‴), est tournée vers la surface intérieure (22 ) du creuset (2, 2', 2", 2‴) délimitant le réceptacle (25).

9. Capsule haute pression (1) selon l'une des revendications précédentes, dans laquelle le creuset (2, 2', 2", 2‴) et/ou le couvercle (3) comportent au moins un métal, et sont notamment réalisés de l'acier.

10. Procédé de fabrication d'une capsule haute pression (1), notamment d'une capsule haute pression selon l'une des revendications précédentes, avec un creuset (2, 2', 2", 2‴) et un couvercle (3) pour fermer le creuset (2, 2', 2", 2‴), le procédé comprenant l'étape consistant à :
- revêtir la capsule haute pression (1) au moins dans certaines zones d'un revêtement (4) comprenant au moins une couche de carbone amorphe, dans lequel le revêtement (4) est disposé au moins dans certaines zones sur une surface (22, 32, 32') de la capsule haute pression (1) tournée vers un espace de réception (24), et dans lequel le creuset (2, 2', 2", 2‴) est réalisé en acier.

11. Procédé selon la revendication 10, dans lequel le revêtement est réalisé par dépôt de carbone amorphe au moyen d'un dépôt chimique et/ou physique en phase gazeuse, de préférence au moyen d'un dépôt chimique en phase gazeuse assisté par plasma.

12. Procédé selon la revendication 11, dans lequel le dépôt a lieu à une température comprise entre 150°C et 300°C, notamment entre 180°C et 250°C.

13. Procédé selon l'une des revendications 10 à 12, dans lequel avant de revêtir la capsule haute pression (1) avec l'enrobage (4), au moins une couche adhésive est appliquée par pulvérisation cathodique sur le creuset (2, 2', 2", 2‴) et / ou le couvercle (3), et dans lequel la couche adhésive comprend une couche de nitrure, en particulier du nitrure de chrome ou une couche de titane.

14. Procédé selon l'une des revendications 10 à 13, un revêtement supplémentaire (5) comprenant au moins un métal, notamment de l'or, étant appliqué sur le creuset (2, 2', 2", 2‴) et/ou le couvercle (3).
